Europäisches Patentamt

European Patent Office

Office européen des brevets

(19)

(11) Publication number: **0 149 317**

**A2**

(12) **EUROPEAN PATENT APPLICATION**

(21) Application number: **84307928.6**

(22) Date of filing: **15.11.84**

(51) Int. Cl.⁴: **H 05 K 3/28**
**H 05 K 3/46**

(30) Priority: **13.01.84 GB 8400954**

(43) Date of publication of application:
**24.07.85 Bulletin 85/30**

(84) Designated Contracting States:
**AT BE CH DE FR IT LI LU NL SE**

(71) Applicant: **STANDARD TELEPHONES AND CABLES PUBLIC LIMITED COMPANY**
**190 Strand**
**London, WC2R 1DU(GB)**

(72) Inventor: **Heeks, John Stuart**
**6, Staffords Churchgate Street**
**Harlow Essex(GB)**

(72) Inventor: **Mun, Joseph**
**204A Old Road**
**Harlow Essex(GB)**

(72) Inventor: **Plumb, Richard Gordon**
**2, Elmwood**
**Sawbridgeworth Herts.(GB)**

(74) Representative: **Dennis, Mark Charles**
**STC Patent Department Edinburgh Way**
**Harlow Essex CM20 2SH(GB)**

(54) **Circuit packaging.**

(57) In a circuit assembly a plurality of devices (16) are disposed on a common laminar carrier (11) and are covered with a layer (12, 17) of an insulating material. Metallised interconnect tracks are provided on the layer (12, 17) between the devices.

EP 0 149 317 A2

Croydon Printing Company Ltd.

J.S. Heeks-J. Mun-R.G.S. Plumb
42-9-3

## CIRCUIT PACKAGING

This invention relates to packaging of integrated circuits and hybrid circuits.

High speed integrated circuits, typically of gallium arsenide, are at present under development and prototype chips in reasonable quantities are being produced by pilot lines. The full potential of the circuit chips is not readily achieved due to the non-availability of industrial standard packages. Small high frequency packages exist for discrete microwave devices but they are wholly unsuitable for complex digital and linear circuits. There are also many LSI multipin packages available but these are not suitable for use at very high frequencies.

The object of the present invention is to minimise or to overcome these disadvantages.

According to the invention there is provided a circuit assembly, including a laminar carrier, a plurality of semiconductor devices disposed on the chip carrier, one or more layers of an insulating material covering said devices, characterised in that said insulating material provides a planar surface over said devices, and that one or more metallisation layers are provided on said surface whereby said devices are interconnected.

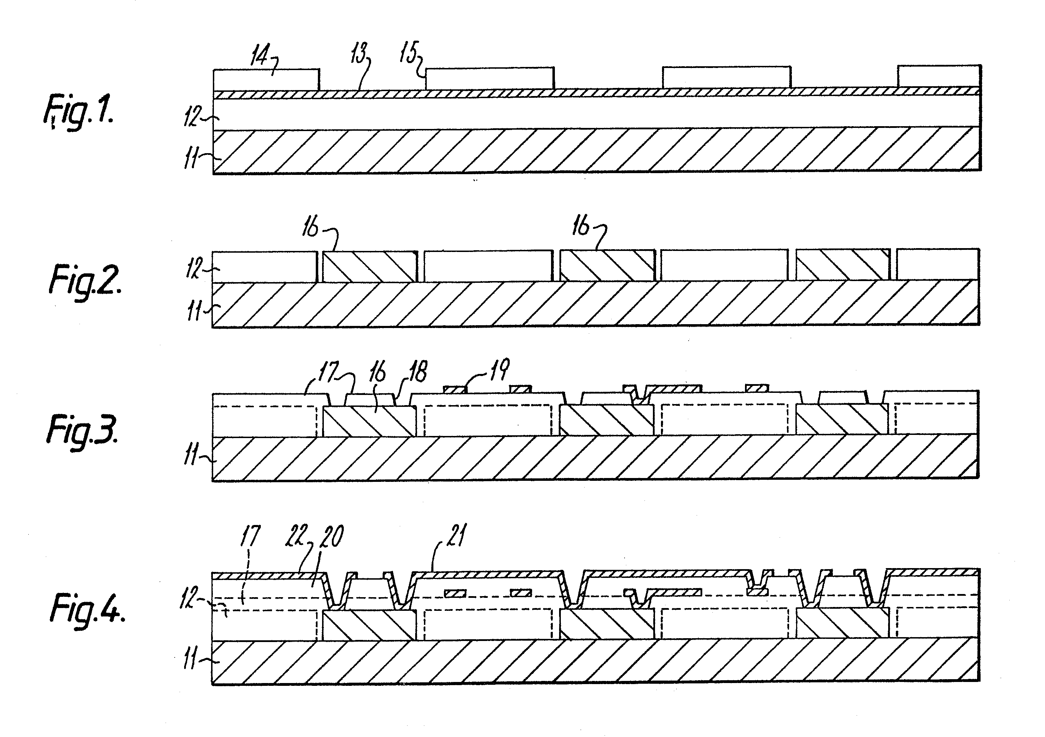

An embodiment of the invention will now be described with reference to the accompanying drawings in which Figs. 1 to 4 illustrate successive stages in the fabrication of a circuit assembly.

Referring to the drawings, the circuit assembly is disposed on a carrier 11 (Fig. 1) the surface of which is coated with a thick layer 12 of an insulating material, e.g. a polyimide. The carrier may be conductive, e.g. a metal, or non-conductive, e.g. a ceramic. Advantageously the carrier material is thermally matched to the semiconductor devices supported thereon. In some applications, e.g. in the construction of a photodiode/amplifier assembly, the carrier 11 may be transparent to allow illumination from beneath the device. Such an arrangement may be used in an optical transmission system.

The layer 12 is coated with a thin layer 13 of silicon nitride and is then selectively masked with a photoresist 14. The assembly is etched through the mask, e.g. by a two stage reactive ion etching process, to provide windows 15 (Fig. 2) in the layer 12. These windows 15 each locate a semiconductor or other device 16, typically a gallium arsenide integrated circuit. A further planarizing layer 17 (Fig. 3), e.g. of polyimide is deposited to form a substantially plane surface for subsequent processing.

Openings 18 are next etched in the layer 17 to expose the terminal regions of the devices 16 and a first metallisation or interconnect layer 19 is deposited through a suitable mask e.g. by vacuum evaporation. A further polyimide layer 20 (Fig. 4) may then be added followed by further etching and metallisation steps to form a second layer 21 of metallised interconnections. This upper metallisation pattern 21 includes bonding pads 22 whereby external connection to the circuit assembly may be made.

Leads may be attached to the bond pads 22 and the assembly may be flip mounted on to a circuit board. Alternatively the assembly may be mounted in a multipin ceramic package with input and output pins in the form of coplanar transmission lines. To minimise impedance mismatching the input pins may be terminated with thick film resistors.

In addition to its use with high frequency gallium arsenide circuits the technique is also suitable for the packaging of photodiode/amplifier hybrid combinations. Typical hybrid combinations include, but are not limited to, a GaInAs photodiode and a GaAs MESFET amplifier, a GaInAs photodiode and a silicon bipolar amplifier, or a silicon photodiode and an InGaAs amplifier.

Whilst the circuit assembly has been described with reference to integrated circuits it will be clear that other active and/or passive devices can also be interconnected on a common carrier in this manner.

CLAIMS:-

1.    A circuit assembly, including a laminar carrier, a plurality of semiconductor devices disposed on the chip carrier, one or more layers of an insulating material covering said devices, characterised in that said insulating material provides a planar surface over said devices, and that one or more metallisation layers are provided on said surface whereby said devices are interconnected.

2.    A circuit assembly as claimed in claim 1, characterised in that said carrier is electrically conductive.

3.    A circuit assembly as claimed in claim 1, characterised in that the devices are gallium arsenide integrated circuits.

4.    A circuit assembly as claimed in claim 1, characterised in that said carrier is optically transparent.

5.    A circuit assembly as claimed in claim 4, and including a photodiode/amplifier hybrid combination.

6.    A circuit assembly as claimed in claim 5, and including a gallium indium arsenide photodiode.

7.    A circuit assembly as claimed in claim 6 and including a gallium arsenide MESFET amplifier or a silicon bipolar amplifier.

8.    A circuit assembly as claimed in any one of claims 1 to 7, characterised in that said insulating material is a polyimide.

9.    A method of mounting a plurality of circuit devices on a common laminar carrier, the method including covering said devices with a substantially planar layer of an insulating material whereby said devices are secured to the carrier, providing one or more metallised interconnect patterns over the insulating layer, and providing contacts from the interconnect patterns to the devices.

10. A method as claimed in claim 9, characterised in that two layers of metallisation are provided.

11. A method as claimed in claim 9 or 10, characterised in that said insulating layer comprises lower and upper portions, the lower portion having openings whereby the devices are positioned relative to the carrier.

12. A method as claimed in claim 9, 10 or 11, characterised in that the assembly is mounted in a package provided with coplanar transmission lines for the input connections.

13. A method as claimed in claim 12, characterised in that the input connections are terminated each with a resistor.

14. An optical transmission system incorporating a circuit assembly as claimed in any one of claims 1 to 8.

Fig.1.

Fig.2.

Fig.3.

Fig.4.